# EUROPEAN PATENT APPLICATION

(11) **EP 4 826 651 A1**
(43) Date of publication of application: **21.10.2026**
(21) Application number: 26171272.3
(22) Date of filing: 08.04.2026
(51) Int. Cl.: G06T 7/11, G06T 7/194

(54) **TWO-STAGE SEGMENTATION OF PARTICLES IN ELECTRON MICROSCOPE IMAGE**

(30) Priority: 14.04.2025 JP 2025066327
(71) Applicant: Jeol Ltd., Akishima, Tokyo 196-8558 (JP)
(72) Inventor: TAKEI, Masahiko, Tokyo, 196-8558 (JP); TAKASHIMA, Yoshiko, Tokyo, 196-8558 (JP); MORITA, Masaki, Tokyo, 196-8558 (JP); NAKAMURA, Motohiro, Tokyo, 196-8558 (JP)
(74) Representative: Boult Wade Tennant LLP

(57) **Abstract**

A segmentation model (40) identifies a filter region in an original image (37), to thereby produce a primary mask image (43). A non-filter region analyzer (44) specifies a representative coordinate belonging to a non-filter region within the primary mask image (43). The representative coordinate is supplied to the segmentation model (40) as a prompt (P2). The segmentation model (40) identifies a particle region in the original image (37), to thereby produce a secondary mask image.

## Description

### TECHNICAL FIELD

The present disclosure relates to an image processing apparatus and an image processing method, and in particular to processing of an electron microscope image including a particle image.

### BACKGROUND

Electron microscopes are used for particle analysis. For example, a filter containing a plurality of captured asbestos particles is observed with the electron microscope. With this process, an electron microscope image including a filter image and a plurality of particle images is produced. Through analysis of the electron microscope image, for example, the number of asbestos particles is counted, a position of each asbestos particle is identified, or a shape of each asbestos particle is evaluated. The filter is generally formed from a fibrous material or a porous material. In the electron microscope image described above, the filter image normally has a complicated, unique pattern.

Document 1 describes a charged particle beam apparatus having a learned model. Document 1 does not describe stepwise segmentation. Documents 2 and 3 disclose typical segmentation models. A coordinate or a region is supplied as a prompt to a segmentation model. The prompt corresponds to a designation or an instruction of an image of interest. Documents 2 and 3 do not describe specific techniques for analyzing particles.

### DOCUMENT LIST

Document 1: WO 2021/044532
Document 2: Alexander Kirillov et al., Segment Anything, Meta AI Research, FAIR
[arXiv:2304.02643v1 [cs.CV] 5 Apr 2023]
Document 3: Nikhila Ravi et al., SAM 2: Segment Anything in Images and Videos, Meta FAIR [arXiv:2408.00714v2 [cs.CV] 28 Oct 2024]

An electron microscope image acquired through observation of a filter containing particles includes, in addition to a particle image, a filter image serving as a background image. The filter image has a complicated, unique pattern. It is difficult to directly identify a particle image from such an electron microscope image. A method may be considered in which the particle image is identified from the electron microscope image using a segmentation model which has been machine learned. Still, in this case also, the filter image obstructs extraction of the particle image. In the following, a region where the particle image is present will be called a "particle region."

An advantage of the present disclosure lies in highly precise identification of a particle region in an electron microscope image.

### SUMMARY

According to one aspect of the present disclosure, there is provided an image processing apparatus comprising: a processor configured to process an original image produced through observation of a particle on a filter with an electron microscope, wherein the processor is configured to: identify a filter region based on the original image, to thereby produce a primary mask image representing the filter region; specify position information of a non-filter region within the primary mask image; and identify a particle region instructed by the position information based on the original image, to thereby produce a secondary mask image representing the particle region.

According to another aspect of the present disclosure, there is provided an image processing method executed in an information processing apparatus, the method comprising: inputting an original image produced through observation of a particle on a filter with an electron microscope; identifying a filter region based on the original image, to thereby produce a primary mask image representing the filter region; specifying position information of a non-filter region within the primary mask image; and identifying a particle region instructed by the position information based on the original image, to thereby produce a secondary mask image representing the particle region.

### BRIEF DESCRIPTION OF DRAWINGS

Embodiment(s) of the present disclosure will be described based on the following figures, wherein:
FIG. 1 is a diagram showing an example configuration of a particle analysis system according to embodiments of the present disclosure;
FIG. 2 is a diagram showing a particle analysis method according to a first embodiment of the present disclosure;
FIG. 3 is a diagram showing an original image;
FIG. 4 is a diagram showing image contrast adjustment;
FIG. 5 is a diagram showing an enlarged image;
FIG. 6 is a diagram showing a primary mask image;
FIG. 7 is a diagram showing a plurality of representative coordinates;
FIG. 8 is a diagram showing a provisional representative coordinate and a representative coordinate;
FIG. 9 is a diagram showing a reduced image;
FIG. 10 is a diagram showing a plurality of secondary prompts;
FIG. 11 is a diagram showing a secondary mask image;
FIG. 12 is a diagram showing a particle analysis method according to a second embodiment of the present disclosure;
FIG. 13 is a diagram showing cropping of a plurality of input images from an enlarged image;
FIG. 14 is a diagram showing merger of a plurality of output images which are trimmed;
FIG. 15 is a diagram showing a first example display;
FIG. 16 is a diagram showing a second example display;
FIG. 17 is a diagram showing a scheme selection method;
FIG. 18 is a diagram showing a particle analysis method according to a third embodiment of the present disclosure;
FIG. 19 is a diagram showing a particle region identification process; and
FIG. 20 is a diagram showing a process based on a plurality of representative coordinates.

### DESCRIPTION OF EMBODIMENTS

Embodiments of the present disclosure will now be described with reference to the drawings.

### (1) Overview of Embodiments

An image processing apparatus according to an embodiment of the present disclosure comprises a processor configured to process an original image produced through observation of a particle on a filter with an electron microscope. The processor is configured to identify a filter region based on the original image, to thereby produce a primary mask image representing the filter region. The processor is configured to then specify position information of a non-filter region within the primary mask image. The processor is configured to then identify a particle region instructed by the position information of the non-filter region based on the original image, to thereby produce a secondary mask image representing the particle region.

According to the above-described configuration, first, the filter region is identified, and then, the particle region is identified. Identification of the particle region utilizes information acquired from a result of the identification of the filter region, more specifically, position information of the non-filter region. Through such two-step identification processes, identification precision of the particle region can be improved. When there is no particle on the filter, naturally, the original image does not include the particle region.

More specifically, the filter image has a unique pattern over the entirety of the original image. In general, identification of the filter region is easier in comparison to identification of the particle image. Therefore, the filter region is identified first. From another point of view, this identification is an identification of regions other than the filter region; that is, the non-filter region. The non-filter region normally includes the particle region, but the non-filter region may also include regions other than the particle region (for example, an unclear region). It is not appropriate to presume that the non-filter region is the particle region. In consideration of this, the position information of the non-filter region is utilized. The position information is information for specifying a position where the non-filter region is present. In the identification of the particle region based on the original image, the position information is taken into consideration. That is, an identification target is narrowed down with the position information.

The filter region is directly or indirectly identified from the original image. For example, the filter region may be identified from an enlarged image produced based on the original image. The particle region is directly or indirectly identified from the original image. For example, the particle region may be identified from a reduced image produced based on the original image.

In an embodiment of the present disclosure, the position information is a representative coordinate. The processor is configured to identify the particle region including the representative coordinate. The representative coordinate is a coordinate within the non-filter region, and is, for example, a center-of-gravity coordinate or a center coordinate of the non-filter region.

In an embodiment of the present disclosure, the processor has a primary segmentation model which identifies the filter region. The processor also has a secondary segmentation model which identifies the particle region. The position information is supplied to the secondary segmentation model as a prompt for instructing an identification target. In an embodiment of the present disclosure, the primary segmentation model and the secondary segmentation model are identical models.

The filter region is identified by the primary segmentation, and the particle region is identified by the secondary segmentation. In the secondary segmentation, the position information derived from the result of the primary segmentation is utilized as the prompt. The position information is information for specifying the position of the non-filter region. The position information is, for example, a coordinate within the non-filter region, or information indicating a position and a size of a figure (bounding box) surrounding the non-filter region. When the non-filter region includes regions other than the particle region, it is more advantageous to utilize the representative coordinate as the prompt.

In an embodiment of the present disclosure, the processor is configured to apply coordinate conversion on the position information according to a coordinate system of the secondary segmentation model. Position information after the coordinate conversion is supplied to the secondary segmentation model as the prompt.

In an embodiment of the present disclosure, the processor is configured to produce an enlarged image by enlarging the original image, and identify the filter region based on the enlarged image. The processor is also configured to produce a reduced image by reducing the original image, and identify the particle region based on the reduced image. By identifying the filter region based on the enlarged image, the identification precision of the filter region; that is, the identification precision of the non-filter region, can be improved. By identifying the particle image based on the reduced image, an amount of calculation or a number of calculations can be reduced. Because the position information is supplied during the identification of the particle image, the identification precision of the particle image can be improved.

In an embodiment of the present disclosure, the processor is configured to calculate a provisional representative coordinate based on the non-filter region. The processor is configured to determine the provisional representative coordinate as the representative coordinate when the provisional representative coordinate belongs to the non-filter region. On the other hand, when the provisional representative coordinate does not belong to the non-filter region, the processor is configured to determine a coordinate within the non-filter region as the representative coordinate based on the provisional representative coordinate. According to this configuration, even when the non-filter region has a form that is not typical or a form that is unnatural, the particle region can be reliably identified.

In an embodiment of the present disclosure, the filter region is a first filter region, the non-filter region is a first non-filter region, the primary mask image is a first primary mask image, the position information is first position information, the particle region is a first particle region, and the secondary mask image is a first secondary mask image. The processor is configured to produce an enlarged image by enlarging the original image, and identify a second filter region within the enlarged image, to thereby produce a second primary mask image representing the second filter region. The processor is configured to then specify second position information of the second non-filter region within the second primary mask image. The processor is configured to then identify a second particle region instructed by the second position information based on the original image, to thereby produce a second secondary mask image representing the second particle region. The processor is further configured to synthesize the first secondary mask image and the second secondary mask image, to produce a synthesized secondary mask image.

According to the above-described configuration, particle regions of various sizes, from smaller particle regions to larger particle regions, can be identified with high precision. In other words, omission of identification can be prevented or reduced.

In an embodiment of the present disclosure, the processor is configured to produce a first reduced image by reducing the original image, and identify the first particle region within the first reduced image. In addition, the processor is configured to produce a second reduced image by reducing the original image, and identify the second particle region within the second reduced image. According to this configuration, an amount of calculation or a number of calculations can be reduced. In an embodiment of the present disclosure, the first reduced image and the second reduced image are identical images.

In an embodiment of the present disclosure, the processor is configured to select one scheme from among a first scheme and a second scheme, based on a particle size which is designated. The processor is configured to execute particle analysis based on the first secondary mask image when the first scheme is selected. The processor is also configured to execute particle analysis based on the synthesized secondary mask image when the second scheme is selected. According to the first scheme, an amount of calculation can be reduced. According to the second scheme, possibility of identifying particles of various sizes, from smaller particles to larger particles, can be improved.

In an embodiment of the present disclosure, the processor is configured to determine a rate of enlargement of the enlarged image based on a particle size which is designated. According to this configuration, particles having a size of interest can be identified with high precision.

An image processing method according to an embodiment of the present disclosure is an image processing method executed in an information processing apparatus. The image processing method comprises a first step, a second step, a third step, and a fourth step. In the first step, an original image produced through observation of a particle on a filter with an electron microscope is input. In the second step, a filter region is identified based on the original image, and a primary mask image representing the filter region is thereby produced. In the third step, position information of a non-filter region within the mask image is specified. In the fourth step, a particle region instructed by the position information of the non-filter region is identified based on the original image, and a secondary mask image representing the particle region is thereby generated.

The image processing method may be realized as a function of software. In this case, a program or a program product for executing the image processing method is installed in an information processing apparatus via a network or a transportable storage medium. The information processing apparatus has a non-transitory storage medium which stores the program.

### (2) Details of Embodiments

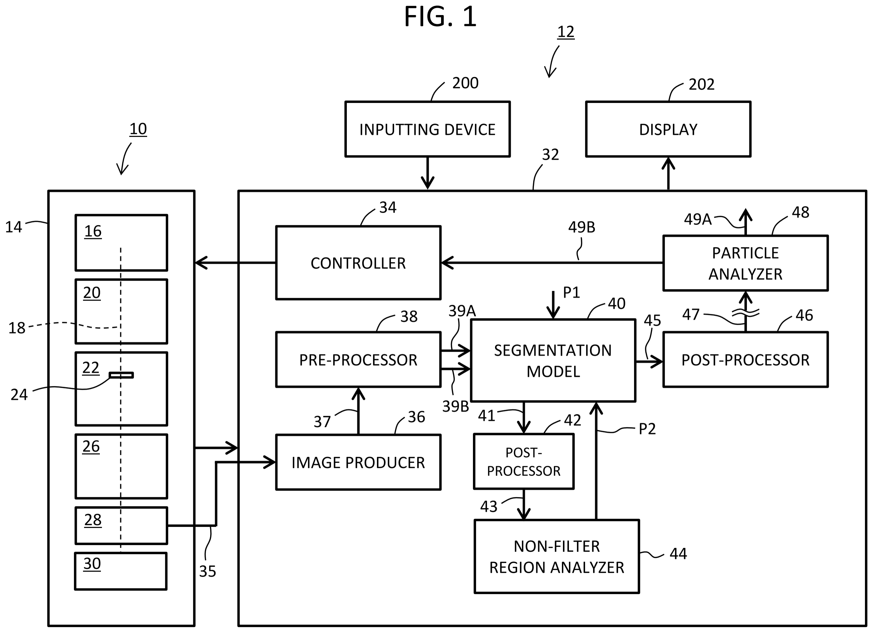

FIG. 1 shows an example configuration of an electron microscope system according to an embodiment of the present disclosure. The illustrated electron microscope system is a particle analysis system, and is more specifically a system which analyzes asbestos particles captured by a filter. The asbestos particle generally has an elongated, needle-like form. Alternatively, other particles may be analyzed.

The electron microscope system comprises a measurement unit 10 and an information processing unit 12. The measurement unit 10 corresponds to a main body of an electron microscope, and more specifically corresponds to a main body of a scanning transmission electron microscope (STEM). Alternatively, other electron microscopes (for example, a scanning electron microscope or a transmission electron microscope) may be employed.

The information processing unit 12 is formed from, for example, a computer serving as an information processing apparatus. The information processing unit 12 comprises a processor 32 which executes a program. The information processing apparatus corresponds to an image processing apparatus serving as a particle analysis apparatus.

The measurement unit 10 comprises an optical column 14. An electron gun 16, an illumination lens system 20, an objective lens 22, an imaging lens system 26, a detector 28, a camera 30, and the like are provided inside the optical column 14. Reference numeral 18 shows an optical axis. In the illustrated example configuration, a sample 24 is provided within the objective lens 22. The sample 24 is a filter containing asbestos particles. Operations of various pieces of equipment in the optical column 14 are controlled by the processor 32.

The electron gun 16 generates an electron beam. Various electron guns may be employed. The illumination lens system 20 may in some cases include an aberration correction apparatus. In the embodiments, the detector 28 is a dark field image detector. A detection signal 35 which is output from the detector 28 is sent to the processor 32. In the optical column 14, a bright field image detector, a two-dimensional detector, and a backscattered electron detector are also provided, but illustration thereof is omitted. Alternatively, an electron microscope image may be produced based on a detection signal which is output from a detector other than the detector 28.

As described above, the information processing unit 12 comprises the processor 32. The processor 32 is formed from a processing device such as a CPU or a GPU. Alternatively, the processor 32 may be formed from a plurality of processing devices. An inputting device 200, a memory (not shown), and a display 202 are connected to the processor 32. The inputting device 200 is formed from a keyboard, a pointing device, or the like. The memory is, for example, a semiconductor memory. The display 202 is, for example, a liquid crystal display.

In FIG. 1, a plurality of functions realized by the processor 32 are expressed by a plurality of blocks. The processor 32 comprises a controller 34, an image producer 36, a pre-processor 38, a segmentation model 40, a post-processor 42, a non-filter region analyzer 44, a post-processor 46, a particle analyzer 48, and the like.

The controller 34 controls scanning of the electron beam. Operations of various pieces of equipment in the optical column 14 are controlled by the controller 34. The image producer 36 produces a scan image serving as the electron microscope image based on a detection signal. The scan image may be called an original image 37. The pre-processor 38 applies a pre-process on the original image. The pre-process may include image contrast adjustment, image size adjustment, and the like. Alternatively, the pre-process may include gamma correction or the like.

The segmentation model 40 is a model which is machine learned, and applies segmentation (object identification) on an input image. In the embodiments, for example, models as described in Documents 2 and 3 are utilized. Alternatively, other models may be utilized. In the embodiments, the segmentation model 40 sequentially executes primary segmentation and secondary segmentation, for processing of one original image. Alternatively, two different segmentation models may be employed for the primary segmentation and the secondary segmentation.

Prior to the primary segmentation, the pre-processor 38 applies a primary pre-process on the original image. The primary pre-process includes image contrast adjustment, gamma correction, image magnification adjustment, image size adjustment, and the like. Prior to the secondary segmentation, the pre-processor 38 applies a secondary pre-process on the original image. Th secondary pre-process includes image contrast adjustment, gamma correction, image magnification adjustment, image size adjustment, and the like. Alternatively, an intermediate image produced by the primary pre-process may be stored, and the secondary pre-process may be applied to the intermediate image. For example, the intermediate image is an image after the image contrast adjustment and the like has been applied. As will be described later in detail, in the primary pre-process, an enlarged image 39A is produced from the original image, and, in the secondary pre-process, a reduced image 39B is produced from the original image.

In the first embodiment of the present disclosure to be described later, in the primary segmentation, two input image are cropped from the enlarged image 39A according to an input specification (input image size) of the segmentation model 40. The two cropped input images are sequentially supplied to the segmentation model 40. In the secondary segmentation, the reduced image 39B is supplied to the segmentation model 40. The reduced image 39B is an input image conforming with the input specification of the segmentation model 40.

In the primary segmentation, for example, as a primary prompt P1, the enlarged image 39A as a whole, or an arbitrary coordinate within a filter region in the enlarged image 39A, is designated. In the former case, the enlarged image 39A as a whole is surrounded by a bounding box. Alternatively, main portions (for example, a portion which does not include or which substantially does not include a non-filter region) of the enlarged image 39A may be surrounded by the bounding box. After the primary prompt is designated, the segmentation model 40 identifies a filter region within the enlarged image 39A, and outputs a primary mask image 41 showing a result of the identification. The designation of the primary prompt P1 is performed by a user, or is performed automatically.

The primary mask image 41 includes a filter region (mask region) and regions other than the filter region (non-filter region). A pixel value of each pixel belonging to the filter region is 1, and a pixel value of each pixel belonging to regions other than the filter region is 0. The filter region is an image which extends over the entirety of the primary mask image. The regions other than the filter region are one or a plurality of non-filter regions. Each non-filter region is a residual region and an isolated region. When there is no asbestos particle on the filter, the primary mask image 41 as a whole may be taken as the filter region; that is, the mask region.

In the first embodiment of the present disclosure to be described later, in the primary segmentation, the segmentation model 40 outputs two output images corresponding to two input images. The post-processor synthesizes the two output images. The post-processor 42 executes, in addition to the image synthesis, image magnification adjustment and the like. A primary mask image 43 after the post-process is output from the post-processor 42.

The non-filter region analyzer 44 identifies one or a plurality of non-filter regions (one or a plurality of non-mask regions) based on the primary mask image 43 after the post-process. The non-filter region analyzer 44 then specifies, as position information of each non-filter region, a coordinate included in the non-filter region as a representative coordinate. The representative coordinate is more specifically a center-of-gravity coordinate. Alternatively, a center coordinate or the like may be specified in place of the center-of-gravity coordinate. Prior to the secondary segmentation, the non-filter region analyzer 44 supplies the specified representative coordinate to the segmentation model 40 as a secondary prompt P2. Alternatively, position information of the bounding box surrounding each filter region may be used as the secondary prompt P2.

In the secondary segmentation, a particle region included in the reduced image 39B which is input is identified by the segmentation model 40. In this case, the representative coordinate designated as the secondary prompt P2 is taken into consideration. In actual practice, a particle image including the representative coordinate is identified as the particle region. The segmentation model 40 produces and outputs a secondary mask image 45 representing a result of the secondary segmentation. The secondary mask image is an image, for example, including one or a plurality of particle regions (one or a plurality of mask regions), and regions other than the particle region (non-mask region). A pixel value of each pixel belonging to each particle region is 1, and a pixel value of each pixel belonging to the regions other than the particle region is 0.

The post-processor 46 executes image magnification adjustment and the like. When the secondary mask image 45 corresponding to the reduced image is output from the segmentation model 40, the post-processor 46 enlarges the secondary mask image 45. A secondary mask image after the post-process 47 is output from the post-processor 46. The secondary mask image after the post-process 47 is a result image. An image synthesizer is provided downstream of the post-processor 46 as necessary.

The particle analyzer 48 executes particle analysis based on the secondary mask image 47. In the particle analysis, for example, the number of particles is counted, the form of each particle is evaluated, and a center coordinate of each particle is specified. Alternatively, a coloring process may be applied to the secondary mask image 47, and the color-processed secondary mask image may be synthesized with the original image. The particle analyzer 48 outputs an image representing an analysis result 49A to the display 202. The particle analyzer 48 outputs, when performing element analysis (point analysis), information 49B indicating a center coordinate of each particle to the controller 34.

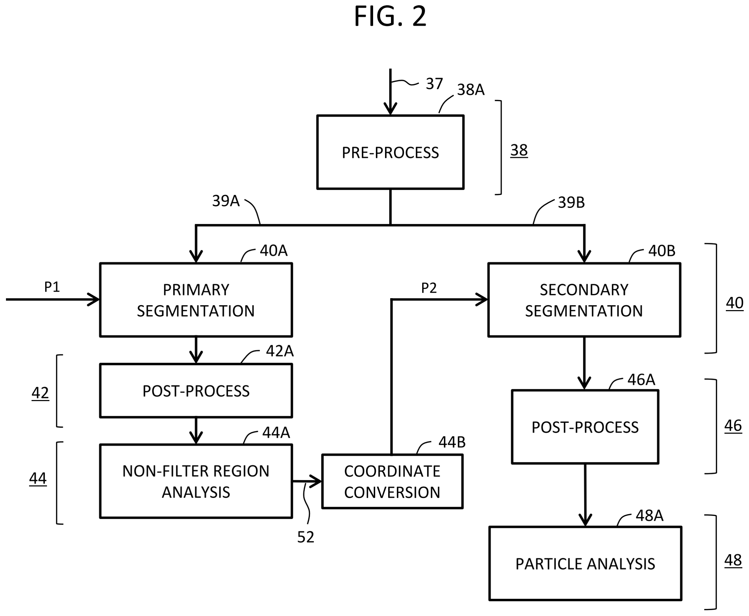

FIG. 2 shows an image processing method according to the first embodiment of the present disclosure. FIG. 2 is a diagram showing an algorithm or a process flow.

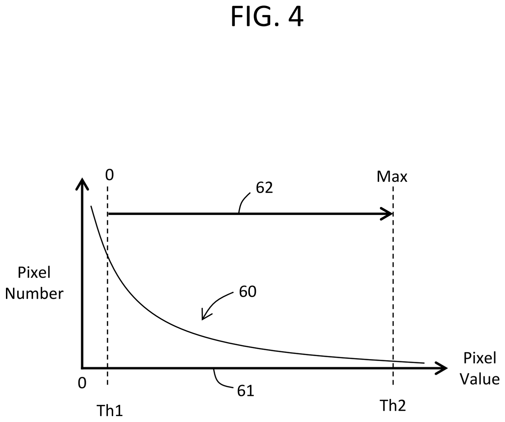

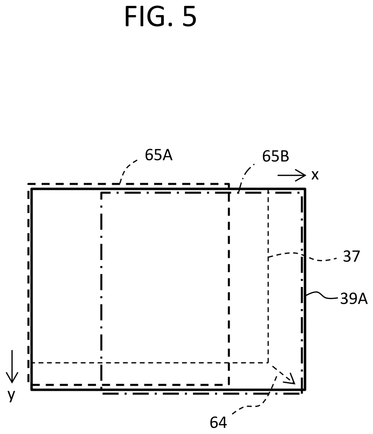

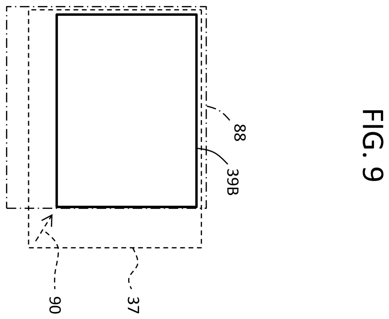

In the pre-processor 38, a pre-process 38A is applied on the original image 37. The pre-processor 38A includes image contrast adjustment to be described later with reference to FIG. 4, image size adjustment (enlargement adjustment) to be described later with reference to FIG. 5, and image size adjustment (reduction adjustment) to be described later with reference to FIG. 9. With the enlargement adjustment, the enlarged image 39A is produced. With the reduction adjustment, the reduced image 39B is produced.

The segmentation model 40 first executes a primary segmentation 40A based on the enlarged image 39A, and then executes a secondary segmentation 40B based on the reduced image 39B.

More specifically, two input images which are cropped from the enlarged image 39A are sequentially supplied to the segmentation model 40. In the primary segmentation 40A, for example, the enlarged image 39A as a whole, or an arbitrary coordinate within the filter region in the enlarged image 39A is designated as the primary prompt P1. This process may alternatively be understood to be designation of the entirety of each input image or a coordinate within each input image as the primary prompt P1. The primary segmentation 40A is applied to each input image. In the primary segmentation 40A, for each input image, the filter region within the input image is identified, and an output image showing the result of the identification is produced. With this process, two output images corresponding to the two input images are produced.

In the post-processor 42, a post-process is applied to the two output images. More specifically, the two output images are synthesized, and a primary mask image after the post-process is produced.

In the non-filter region analyzer 44, non-filter region analysis 44A is applied on the primary mask image after the post-process. More specifically, in each primary mask image after the post-process, each non-filter region is identified, and, then, a center-of-gravity coordinate of each non-filter region is specified as a representative coordinate 52.

In the primary mask image after the post-process, a group of isolated pixels each having the pixel value of 0 is the non-filter region. In the non-filter region analysis 44A, a noise process and a labeling process may be executed as necessary.

In the non-filter region analyzer 44, coordinate conversion 44B is applied to each representative coordinate. The coordinate conversion 44B converts a coordinate according to the coordinate system of the primary mask image to a coordinate according to the coordinate system of the secondary segmentation 40B. Alternatively, the coordinate conversion may be executed in a processing device other than the non-filter region analyzer 44.

In the secondary segmentation 40B, one or a plurality of particle regions included in the reduced image 39B are identified. In this process, one or a plurality of representative coordinates (one or a plurality of representative coordinates after coordinate conversion) supplied as the secondary prompt P2 are taken into consideration. Normally, a coordinate within each particle region is designated by each representative coordinate. With this process, a target of the secondary segmentation 40B is specified, and identification precision of the particle region can be improved. With the execution of the secondary segmentation 40B, a secondary mask image representing one or a plurality of particle regions is produced.

In the post-processor 46, a post-process 46A is applied to the secondary mask image. More specifically, the secondary mask image is enlarged. With this process, a secondary mask image having the same size as the original image is produced. In the particle analyzer 48, particle analysis 48A is applied on the secondary mask image.

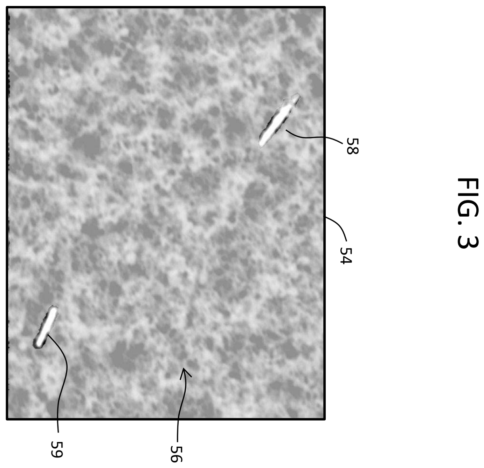

FIG. 3 shows an original image 54. The original image 54 is an image produced by a STEM, and is a scan image and also is a transmission image. The original image 54 includes a filter image 56 having a complicated pattern like a fog, and also includes two particle images 58 and 59. In the example image illustrated in FIG. 3, the particle images 58 and 59 appear relatively clearly, but in many cases, the particle image may be unclear. Depending on a magnification of the original image 54, each particle image may be very narrow and small. In general, it is difficult to directly identify each particle image from the original image 54.

FIG. 4 shows the image contrast adjustment. The horizontal axis is a brightness axis, and the vertical axis is a number-of-pixels axis (frequency axis). Reference numeral 60 shows a histogram of the original image. The horizontal axis corresponds to a first scale 61. The image contrast adjustment converts the first scale 61 into a second scale 62.

Specifically, in the histogram 60, a portion lower than a first threshold Th1 is removed, and a portion higher than a second threshold Th2 is removed. In the second scale 62, the brightness value of 0 corresponds to the first threshold Th1, and a maximum brightness value Max corresponds to the second threshold Th2.

FIG. 5 shows the image size adjustment performed prior to the primary segmentation in the first embodiment of the present disclosure. By enlarging the original image 37 (refer to reference numeral 64), the enlarged image 39A is produced. A y-direction size of the enlarged image 39A coincides with a y-direction size in the input specification of the segmentation model. Two input images 65A and 65B are cropped from the enlarged image 39A, and are sequentially input to the segmentation model. The two input images 65A and 65B partially overlap each other. An x-direction size of each of the input images 65A and 65B coincides with an x-direction size in the input specification of the segmentation model. As described above, the y-direction size of each of the input images 65A and 65B coincides with the y-direction size in the input specification of the segmentation model.

By performing the primary segmentation based on the enlarged image 39A, the identification precision of the non-filter region, and, consequently, the identification precision of the particle region, can be improved while sufficiently taking advantage of the capabilities of the segmentation model.

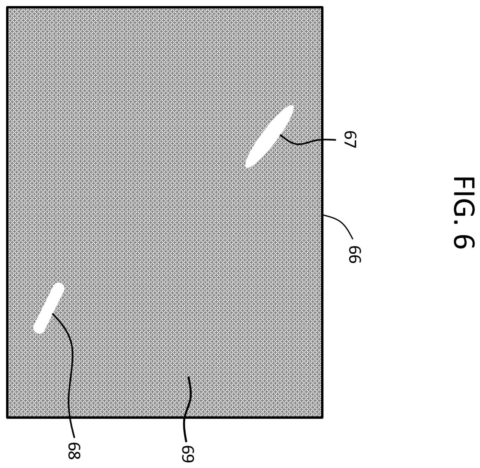

FIG. 6 shows a primary mask image 66. In the primary mask image, the mask region is a filter region 69. Two non-mask regions are non-filter regions 67 and 68.

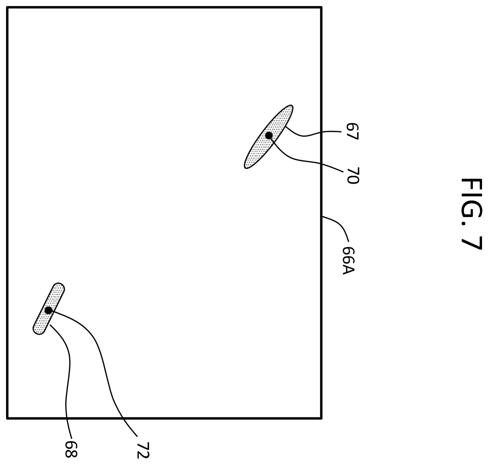

FIG. 7 shows a non-filter region extraction image 66A produced from the primary mask image 66. For the non-filter regions 67 and 68, center-of-gravity points are respectively calculated as representative coordinates 70 and 72. Each of the representative coordinates 70 and 72 is utilized as the secondary prompt.

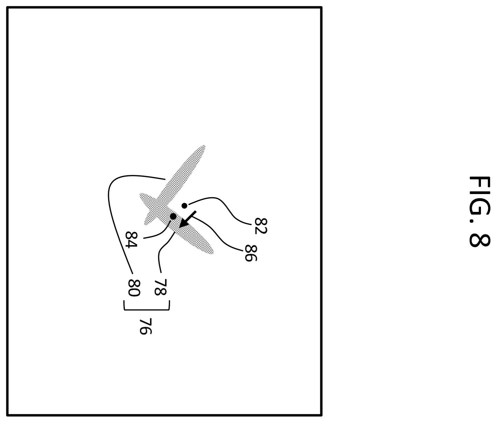

FIG. 8 shows coordinate correction executed in the non-filter region analyzer. The non-filter region 76 corresponds to an image in which two particle images 78 and 80 are combined. A center-of-gravity point is calculated based on the non-filter region 76, and is set as a provisional representative coordinate 82. The provisional representative coordinate 82 is present outside of the non-filter region 76, and, if the provisional representative coordinate 82 is utilized as the secondary prompt, there is a risk that the secondary segmentation cannot be appropriately executed. When the provisional representative coordinate 82 is not present inside the non-filter region 76, for example, a coordinate 84 which is a coordinate belonging to the non-filter region and closest to the provisional representative coordinate 82 is specified, and the coordinate 84 is determined as the representative coordinate (refer to reference numeral 86). On the other hand, if the provisional representative coordinate belongs to the non-filter region, the provisional representative coordinate is determined as the representative coordinate.

FIG. 9 shows the image size adjustment performed prior to the secondary segmentation in the first embodiment of the present disclosure. By reducing the original image 37 (refer to reference numeral 90), the reduced image 39B is produced. An x-direction size of the reduced image 39B coincides with an x-direction size of the input specification (refer to reference numeral 88) of the segmentation model. The reduced image 39B is input to the segmentation model as an input image.

By supplying the reduced image to the segmentation model, the secondary mask image can be produced with a segmentation process performed one time. Thus, an amount of calculation or the number of calculations can be reduced.

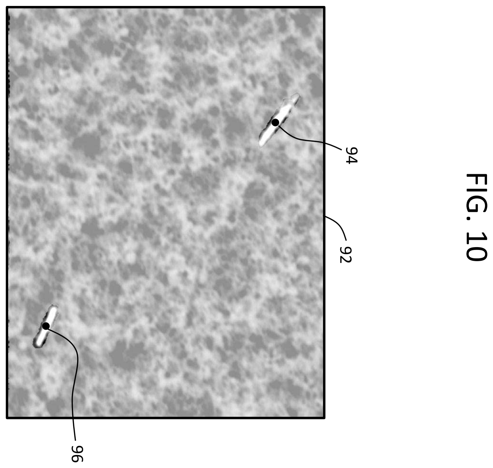

FIG. 10 shows a reduced image 92 which is input to the segmentation model. For the reduced image 92, centers of gravity of two non-filter regions are designated as two prompts 94 and 96. The segmentation model prioritizes identification of objects instructed by the prompts.

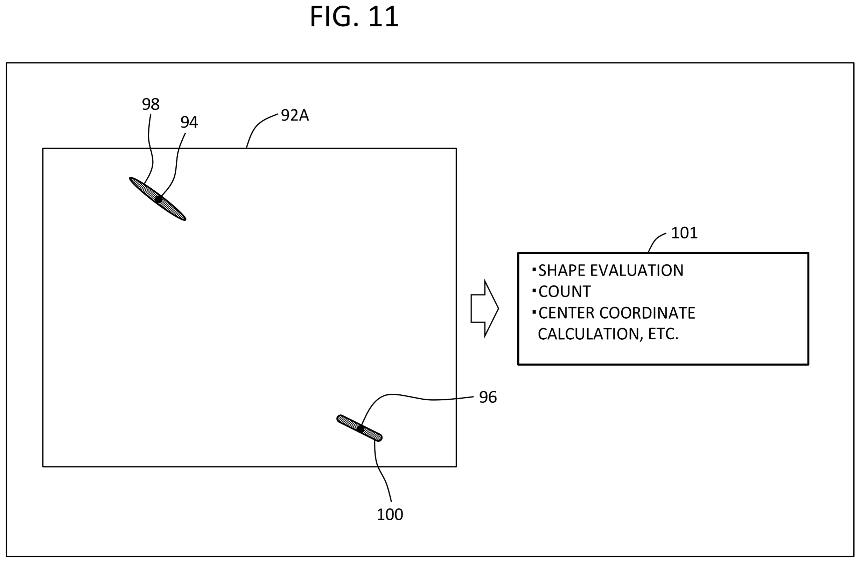

FIG. 11 shows a secondary mask image 92A produced by the secondary segmentation. The secondary mask image 92A includes two particle regions 98 and 100 (two mask regions). The two particle regions 98 and 100 include respective prompts 94 and 96.

Particle analysis 101 is executed based on the secondary mask image 92A. In the particle analysis 101, the shape of the particle is evaluated, and a foreign object region is removed based on the result of the evaluation. In addition, in the particle analysis 101, the number of particle regions is counted, and the center coordinate of each particle region is specified. Alternatively, a width or a length of each particle region may be measured.

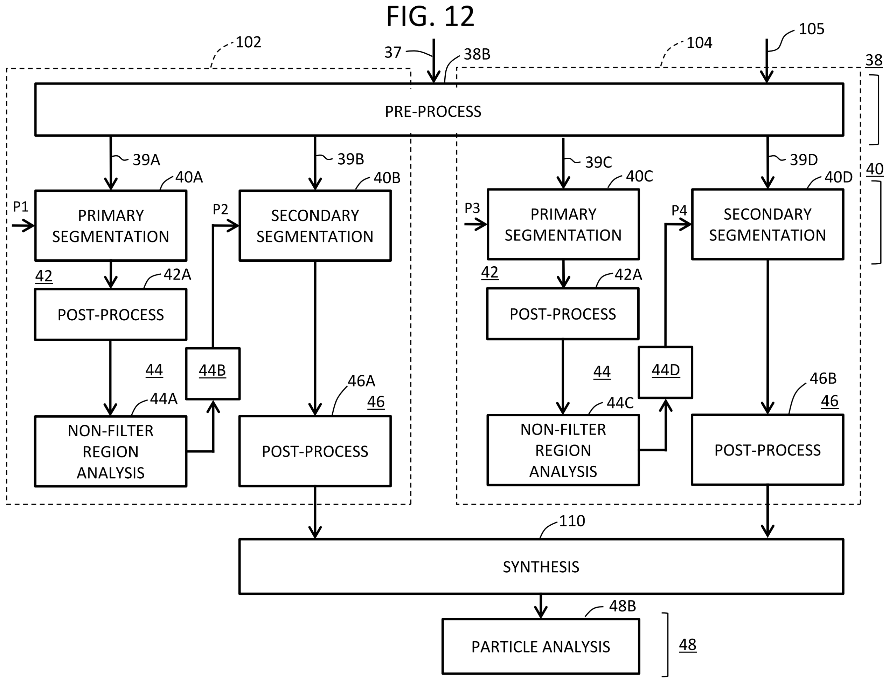

Next, with reference to FIGs. 12 to 17, an image processing method according to a second embodiment of the present disclosure will be described. FIG. 12 shows an algorithm or a process flow according to the second embodiment of the present disclosure. The image processing method according to the second embodiment of the present disclosure has a first module 102 and a second module 104. The first module 102 corresponds to the image processing method according to the first embodiment of the present disclosure. In FIG. 12, elements identical to the elements shown in FIG. 2 are assigned the same reference numerals.

In a pre-process 38B, a first enlarged image 39A, a first reduced image 39B, a second enlarged image 39C, and a second reduced image 39D are produced. The first enlarged image 39A is produced by the process shown in FIG. 5. The first reduced image 39B is produced by the process shown in FIG. 9. The second enlarged image 39C is an image larger than the first enlarged image 39A. The second reduced image 39D is an image identical to the first reduced image 39B.

In the first module 102, with application of the primary segmentation 40A and the post-process 42A on the first enlarged image 39A, a first primary mask image is produced. The non-filter region analysis 44A is applied to the first primary mask image, to thereby specify a representative coordinate for each non-filter region. The coordinate conversion 44B is applied to each representative coordinate. The representative coordinate after the coordinate conversion is supplied to the secondary segmentation 40B as the secondary prompt P2. With application of the secondary segmentation 40B and the post-process 46A on the first reduced image 39B, a first secondary mask image serving as a first result image is produced.

In the second module 104, the second enlarged image 39C is produced from the original image 37 according to a rate of enlargement 105 which is designated. A primary segmentation 40C is applied to the second enlarged image 39C. In this case, the entirety of the second enlarged image 39C is designated as a primary prompt P3. In actual practice, as will be described later, a plurality of input images are cropped from the second enlarged image, and are sequentially input to the segmentation model 40. With this process, a plurality of output images are sequentially output from the segmentation model 40. In the post-processor 42, the plurality of output images are merged, and a second primary mask image is produced.

Non-filter region analysis 44C is applied to the second primary mask image. The non-filter region analysis 44C is basically the same process as the non-filter region analysis 44A. With the non-filter region analysis 44C, a representative coordinate is specified for each non-filter region, and coordinate conversion 44D is applied to each representative coordinate. Each representative coordinate after the coordinate conversion is supplied to a secondary segmentation 40D as a secondary prompt P4. With application of the secondary segmentation 40D and a post-process 46B on the reduced image 39D, a second secondary mask image serving as a second result image is produced.

The first secondary mask image produced by the first module 102 and a second secondary mask image produced by the second module 104 are synthesized (refer to reference numeral 110). The post-processes 46A and 46B are executed in such a manner that the sizes of the two mask images are the same. In FIG. 1, a synthesizer is provided between the post-processor 46 and the particle analyzer 48. In the synthesizer, the two secondary mask images are synthesized, to thereby produce a synthesized secondary mask image (synthesized result image). In the particle analyzer 48 shown in FIG. 12, particle analysis 48B is applied on the synthesized secondary mask image.

According to the second embodiment of the present disclosure, particles with various sizes, from larger size particles to smaller size particles, can be reliably identified. Alternatively, three or more modules corresponding to three or more rates of enlargement may be provided. In the second embodiment of the present disclosure, the rate of enlargement is initially set or is set by the user.

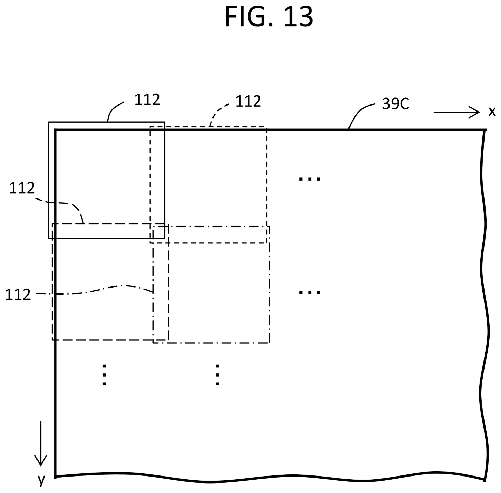

FIG. 13 shows the second enlarged image 39C. The second enlarged image 39C is produced by enlarging the original image in the x direction and in the y direction. A plurality of input images 112 are cropped from the second enlarged image 39C, and are supplied to the segmentation model. The plurality of input images 112 partially overlap each other in the x direction and in the y direction. A size of each input image 112 matches the input specification of the segmentation model.

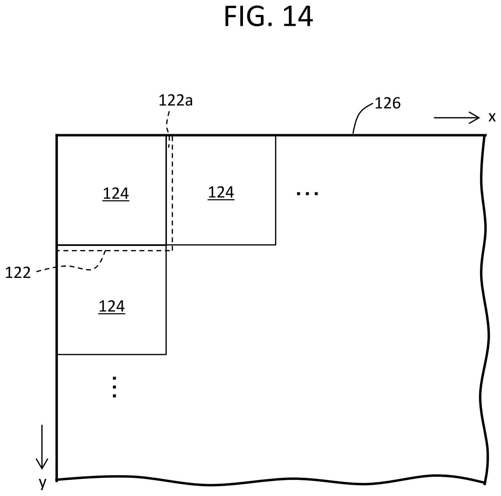

FIG. 14 shows production of a second primary mask image 126. After trimming is applied to a plurality of output images 122 which are output from the segmentation model, a plurality of trimmed output images 124 are merged, to thereby produce the second primary mask image 126. Reference numeral 122a shows a portion which is cut out by the trimming process. In the merger of the plurality of output images 124, there is no partial overlap. Alternatively, the plurality of output images may be merged while causing the partial overlap. A reduction process is applied to the second primary mask image 126, so that the size thereof is the same size as the original image.

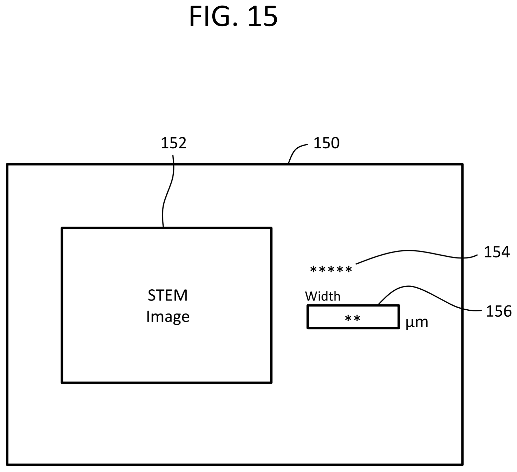

FIG. 15 shows a first example display. An image 150 includes an original image 152 serving as an electron microscope image. A numerical value 154 shows the magnification (observation magnification) of the original image 152. Using an input field 156, the user designates a minimum width (minimum short-side length) of the particle. Based on the minimum width, the rate of enlargement of the second enlarged image is automatically set.

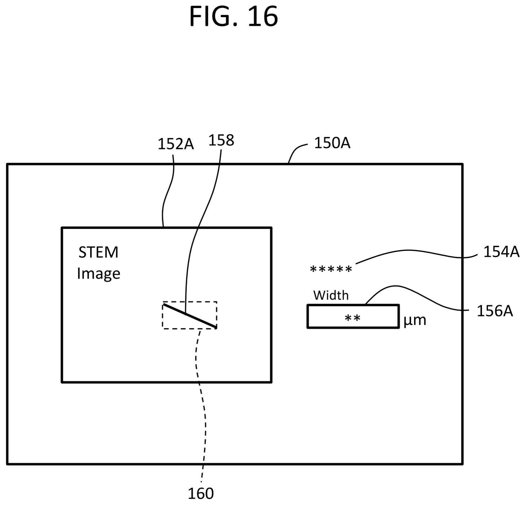

FIG. 16 shows a second example display. An image 150A includes an original image 152A. The original image 152A includes a particle image 158. The user sets a bounding box 160 surrounding the particle image 158. A width of the particle image 158 in the bounding box 160 is measured as a minimum width. In this case, any known algorithm may be employed. The minimum value is displayed as a numerical value 156A along with a numerical value 154A showing the magnification.

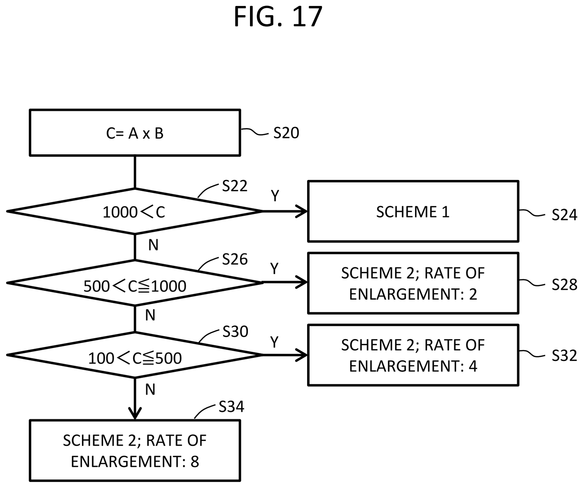

FIG. 17 shows a method of selecting a scheme (and a method of selecting magnification). In a first scheme, the particle analysis is performed according to the first embodiment of the present disclosure, and, in a second scheme, the particle analysis is performed according to the second embodiment of the present disclosure.

In S20, an index C is calculated based on C=AxB. A is the magnification and B is the minimum width. When it is judged in S22 that a condition of 1000<C is satisfied, the first scheme is selected in S24. When it is judged in S26 that a condition of 500<C≤1000 is satisfied, the second scheme is selected and a rate of enlargement of 2 is designated in S28.

When it is judged in S30 that a condition of 100<C≤500 is satisfied, the second scheme is selected and a rate of enlargement of 4 is designated in S32. When it is judged in S30 that C is less than or equal to 100, the second scheme is selected and a rate of enlargement of 8 is designated in S34.

In this manner, by selecting the scheme and the rate of enlargement in consideration of the particle size and the magnification, appropriate particle analysis can be performed.

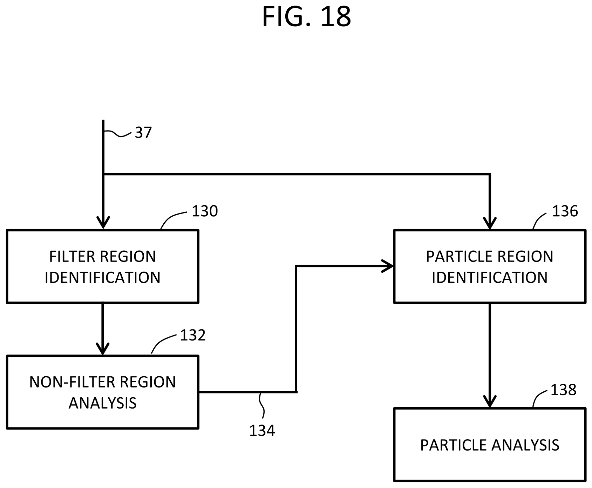

Next, with reference to FIGs. 18 to 20, an image processing method according to a third embodiment of the present disclosure will be described.

In FIG. 18, filter region identification 130 is applied on the original image 37. In this case, an operator or an image filter for identifying the filter region may be employed. As a result of the identification of the filter region, a primary mask image representing one or a plurality of non-filter regions that are identified is produced.

For each non-filter region, non-filter region analysis 132 is applied to the non-filter region. With this process, a representative coordinate 134 is specified. The representative coordinate 134 is used in particle region identification 136. Specifically, in the particle region identification 136, a process is applied in which, with each representative coordinate 134 designated in the original image as a starting point, a region to which the representative coordinate 134 belongs is searched for. Each region identified through the search is a particle region. A secondary mask image representing one or a plurality of particle regions is produced. Particle analysis 138 is applied on the secondary mask image.

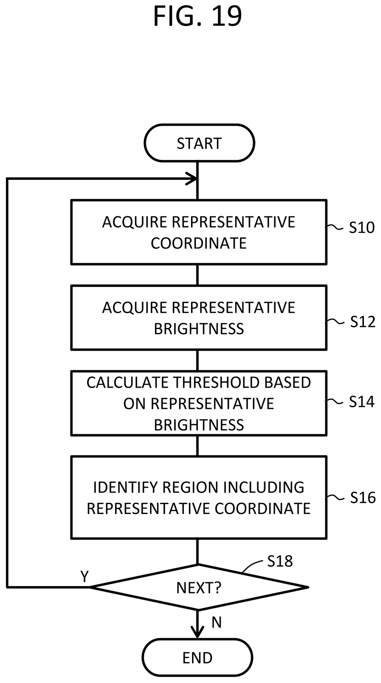

An example of the particle region identification 136 is shown in FIG. 19. In S10, a representative coordinate is acquired, and brightness specified by the representative coordinate (representative brightness) is specified in S12. In S14, a threshold is calculated based on the representative brightness. For example, the original image is binarized using the threshold. In S16, with the representative coordinate as a starting point, a closed region including the representative coordinate is extracted. In S18, if there is a next representative coordinate, the processes from S10 are again executed.

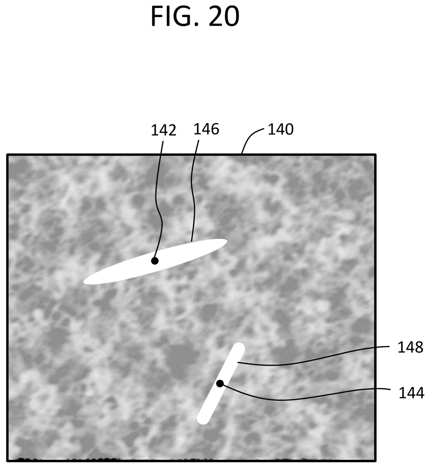

FIG. 20 shows an original image 140. In the illustrated example configuration, two particle regions 146 and 148 are identified based on representative coordinates 142 and 144.

In the third embodiment of the present disclosure, the segmentation model may be utilized in producing the primary mask image, and the segmentation model may be utilized in producing the secondary mask image.

In the embodiments described above, a scanning transmission electron microscope is used. Alternatively, other electron microscopes (the scanning electron microscope and the transmission electron microscope) may be employed. Alternatively, the process of the above-described embodiments may be applied to an image acquired by a charged particle beam apparatus other than the electron microscope.

## Claims

1. An image processing apparatus comprising:
a processor (32) configured to process an original image produced through observation of a particle on a filter with an electron microscope (10), wherein
the processor (32) is configured to:
identify a filter region based on the original image, to thereby produce a primary mask image representing the filter region;
specify position information of a non-filter region within the primary mask image; and
identify a particle region instructed by the position information based on the original image, to thereby produce a secondary mask image representing the particle region.

2. The image processing apparatus according to claim 1, wherein
the position information is a representative coordinate, and
the processor (32) is configured to identify the particle region including the representative coordinate.

3. The image processing apparatus according to claim 1, wherein
the processor (32) has a primary segmentation model which identifies the filter region.

4. The image processing apparatus according to claim 3, wherein
the processor (32) has a secondary segmentation model which identifies the particle region, and
the position information is supplied to the secondary segmentation model as a prompt for instructing an identification target.

5. The image processing apparatus according to claim 4, wherein
the primary segmentation model and the secondary segmentation model are identical models.

6. The image processing apparatus according to claim 4, wherein
the processor (32) is configured to apply coordinate conversion on the position information according to a coordinate system of the secondary segmentation model, and
position information after the coordinate conversion is supplied to the secondary segmentation model as the prompt.

7. The image processing apparatus according to any one of claims 1-6, wherein
the processor (32) is configured to:
produce an enlarged image by enlarging the original image;
identify the filter region based on the enlarged image;
produce a reduced image by reducing the original image; and
identify the particle region based on the reduced image.

8. The image processing apparatus according to claim 2, wherein
the processor (32) is configured to:
calculate a provisional representative coordinate based on the non-filter region;
determine the provisional representative coordinate as the representative coordinate when the provisional representative coordinate belongs to the non-filter region; and
determine a coordinate within the non-filter region as the representative coordinate based on the provisional representative coordinate when the provisional representative coordinate does not belong to the non-filter region.

9. The image processing apparatus according to any one of claims 1-6, wherein
the filter region is a first filter region,
the non-filter region is a first non-filter region,
the primary mask image is a first primary mask image,
the position information is first position information,
the particle region is a first particle region,
the secondary mask image is a first secondary mask image, and
the processor is configured to:
produce an enlarged image by enlarging the original image;
identify a second filter region within the enlarged image, to thereby produce a second primary mask image representing the second filter region;
specify second position information of the second non-filter region within the second primary mask image;
identify a second particle region instructed by the second position information based on the original image, to thereby produce a second secondary mask image representing the second particle region; and
synthesize the first secondary mask image and the second secondary mask image, to produce a synthesized mask image.

10. The image processing apparatus according to claim 9, wherein
the processor (32) is configured to:
produce a first reduced image by reducing the original image;
identify the first particle region within the first reduced image;
produce a second reduced image by reducing the original image; and
identify the second particle region within the second reduced image.

11. The image processing apparatus according to claim 9, wherein
the processor (32) is configured to:
select one scheme from among a first scheme and a second scheme, based on a particle size which is designated;
execute particle analysis based on the first secondary mask image when the first scheme is selected; and
execute particle analysis based on the synthesized secondary mask image when the second scheme is selected.

12. The image processing apparatus according to claim 9, wherein
the processor (32) is configured to determine a rate of enlargement of the enlarged image based on a particle size which is designated.

13. An image processing method executed in an information processing apparatus (12), the method comprising:
inputting an original image produced through observation of a particle on a filter with an electron microscope (10);
identifying (40A) a filter region based on the original image, to thereby produce a primary mask image representing the filter region;
specifying (44A) position information of a non-filter region within the primary mask image; and
identifying (40B) a particle region instructed by the position information based on the original image, to thereby produce a secondary mask image representing the particle region.

14. A program executed by a processor (32) in an information processing apparatus (12), the program causing the processor to execute:
a function to input an original image produced through observation of a particle on a filter with an electron microscope (10);
a function (40A, 40C) to identify a filter region based on the original image, to thereby produce a primary mask image representing the filter region;
a function (44A, 44C) to specify position information of a non-filter region within the primary mask image; and
a function (40B, 40D) to identify a particle region instructed by the position information based on the original image, to thereby produce a secondary mask image representing the particle region.
